(19) Europäisches Patentamt
European Patent Office
Office européen des brevets

(11) **EP 1 716 430 B1**

(12) **EUROPEAN PATENT SPECIFICATION**

(45) Date of publication and mention
of the grant of the patent:
**24.09.2008 Bulletin 2008/39**

(21) Application number: **05702892.0**

(22) Date of filing: **03.02.2005**

(51) Int Cl.:
**G01R 33/561** $^{(2006.01)}$

(86) International application number:
**PCT/IB2005/050458**

(87) International publication number:
**WO 2005/078470 (25.08.2005 Gazette 2005/34)**

(54) **MAGNETIC RESONANCE IMAGING METHOD**

MAGNETRESONANZABBILDUNGSVERFAHREN

PROCEDE D'IMAGERIE PAR RESONANCE MAGNETIQUE

(84) Designated Contracting States:
**AT BE BG CH CY CZ DE DK EE ES FI FR GB GR HU IE IS IT LI LT LU MC NL PL PT RO SE SI SK TR**

(30) Priority: **10.02.2004 EP 04100486**

(43) Date of publication of application:
**02.11.2006 Bulletin 2006/44**

(73) Proprietors:
• **Koninklijke Philips Electronics N.V.**
**5621 BA Eindhoven (NL)**
Designated Contracting States:
**AT BE BG CH CY CZ DK EE ES FI FR GB GR HU IE IS IT LI LT LU MC NL PL PT RO SE SI SK TR**
• **Philips Intellectual Property & Standards GmbH**
**20099 Hamburg (DE)**
Designated Contracting States:
**DE**

(72) Inventors:
• **FUDERER, Miha**
**NL-5656 AA Eindhoven (NL)**
• **EGGERS, Holger**
**NL-5656 AA Eindhoven (NL)**

(74) Representative: **Cohen, Julius Simon**
**Philips**
**Intellectual Property & Standards**
**P.O. Box 220**
**5600 AE Eindhoven (NL)**

(56) References cited:
WO-A-20/04104611             US-A1- 2002 014 889
US-A1- 2003 122 545

• BYDDER M ET AL: "Generalized SMASH imaging" MAGNETIC RESONANCE IN MEDICINE, ACADEMIC PRESS, DULUTH, MN, US, vol. 47, no. 1, January 2002 (2002-01), pages 160-170, XP002204471 ISSN: 0740-3194

**Description**

The invention relates to a magnetic resonance (MR) technique for forming an image of an object wherein a set of non-linear trajectories in k-space is acquired, wherein the density of said set of trajectories is substantially lower than the density corresponding to the object size. Signals along these trajectories are sampled by means of one or more receiving antennae, and a magnetic resonance image is derived from these signals and on the basis of the spatial sensitivity profile of the set of receiving antennae. The invention notably pertains to a magnetic resonance imaging technique in which magnetic resonance signals are acquired by means of a receiver antennae system, and a magnetic resonance image is reconstructed on the basis of the magnetic resonance signals.

US 2002/014889 discloses a magnetic resonance imaging method wherein a magnetic resonance image is reconstructed from magnetic resonance signals from respective signal channels. More specifically, individual signal channels relate to respective surface coils which are employed as receiver antennas for the magnetic resonance signals. The magnetic resonance signals are acquired with sub-sampling of the k-space. Resampling on a regular square grid is performed, thus enabling fast Fourier transformation in the reconstruction of the magnetic resonance image. Furthermore, the reconstruction is carried out on the basis of the spatial sensitivity profile of the receiver antennas, i.e. of the surface coils, so as to separate contributions from different spatial positions in the sub-sampled magnetic resonance signals. Preferably, a spiral-shaped acquisition trajectory is followed in the k-space.

WO 01/73463 discloses a magnetic resonance imaging method in which the magnetic resonance signals are acquired by scanning along a trajectory in k-space. The known magnetic resonance imaging method offers a high degree of freedom in choosing the acquisition trajectory to be followed through k-space. Notably, acquisition trajectories, notably spiral shaped trajectories, which give rise to irregular sampling patterns in k-space may be used.

Normally, in parallel imaging as SENSE (Pruessmann) or SMASH (Sodickson) the reconstruction of the image is performed by a Cartesian gridding of k-space or image space, respectively.

In US-A-2003/0122545 a magnetic resonance imaging method is described wherein the degree of sub-sampling is chosen such that the ensuing acquisition time for receiving (echo) series of magnetic resonance signals due to an individual RF excitation is shorter than the decay time of the MR signals. Preferably, a segmented scan of the k-space is performed, the number of segments and the number of lines scanned in each segment being adjustable and a predetermined total number of lines being scanned. A small number of segments is used such that the acquisition time for receiving the magnetic resonance signals for the complete magnetic resonance image is shorter than the process time of the dynamic process involved. Although the method is described with a scanning trajectory of straight lines in k-space also other trajectories like curved lines as arcs of circle or spirals could be possible. However, in such case more complex frequency and phase encoding of the magnetic resonance signals will be required. A specific solution for continuous non-Cartesian trajectories in k-space is not described.

In an article of M. Bydder et al. in Magn. Reson. Med 10 (2002) it is mentioned that partially parallel imaging techniques for reconstruction of under-sampled k-space data from multiple coils may be used with arbitrary acquisition schemes (e.g. Cartesian, spiral etc.) by casting the problem as a large linear system of equations. For realistic applications, however, the computational costs for solving this system directly is prohibitive. To date there is no realistic solution for a procedure of fast reconstruction of grossly undersampled data on a continuous non-Cartesian trajectory especially as spiral sampling in k-space.

An object of the present invention is to further reduce the computational effort involved in the reconstruction of the magnetic resonance imaging method from the acquired magnetic resonance signals. The invention is defined by the independent claims. The dependent claims define advantageous embodiments.

The present invention is based on the following insights. In order to achieve a fast reconstruction, e.g. techniques such as fast Fourier transformation (FFT) are employed. As input, these techniques require that data are sampled on a regular sampling grid. Further, a wide class of acquisition trajectories in k-space, notably spiral shaped trajectories and trajectories that include spiral segments are accurately or at least fairly approximated by (almost) parallel segments of the trajectory in respective sector shaped regions of k-space. In general, sector shaped regions may be regions of k-space which have a main axis that passes through the origin of k-space. Such sector shaped regions extend between angular boundaries, that is between a respective minimum and maximum modulus of the k-vector to the periphery of k-space and are bounded by radial boundaries that extend radially from the origin ofk-space. The sector shaped regions may be full sectors which extend from or through the origin of k-space into the periphery of k-space. In two dimensions the sector shaped regions are flat sectors or sector segments or sectors that extend point-symmetrically through the origin of k-space, in three dimensions the sector shaped regions are cones or portions of cones in k-space. According to the invention, the reconstruction which involves a re-gridding to re-sample the acquired magnetic resonance signals to re-sampled magnetic resonance signals on the regular grid is performed separately for the individual sector shaped regions. The re-gridding involves a convolution with a gridding kernel. The gridding kernel depends on the orientation of the sector shaped region at issue so as to account for the appropriate direction in the image space into which aliasing will occur due to the Fourier relationship between pixel-values of the magnetic resonance image and the re-sampled magnetic resonance signals in k-space. Further, the gridding kernel involves the sensitivity profile of the receiver antennae system in order to take account of aliasing that is caused by undersampling of the acquired magnetic resonance signals. To derive the gridding kernel on the basis of the orientation of the sector shaped region and on the basis of the sensitivity profile does not require much computational effort. The computational effort is notably reduced because aliasing is caused by a comparatively small number of pixels or voxels. Accordingly, matrix inversions are only needed for matrices having a relatively low dimensionality. The actual re-sampling onto the regular grid, such as a Cartesian square lattice, involves only convolution with the gridding kernel which takes only little computational effort. The final reconstruction of the magnetic resonance image is then performed by a FFT technique that takes only a short computation time.

It appears that the dependence on the orientation of the sector shaped region in k-space of the gridding kernel involves a quite smooth variation. Accordingly, the gridding kernel for a particular orientation is also accurately valid for rather wide sectors in k-space.

It is also an object of the present invention to provide a magnetic resonance imaging method enabling a fast reconstruction of grossly undersampled non-Cartesian sampling in k-space, especially along a spiral trajectory. It is a further object of the present invention to provide a system and a computer program product for performing such a method.

It is a main advantage of the present invention that formulations of SPACE-RIP and non-Cartesian SENSE are derived that represent coil sensitivity information in the Fourier domain. Due to the small number of Fourier terms required, the linear system is highly sparse and so allows efficient solution of the equations. Thus, spiral scanning is made feasible at a high degree of undersampling so that a very fast acquisition and reconstruction is achieved.

The main aspect of the present invention is that a non-Cartesian trajectory in k-space can be described locally by a coordinate system of imaginary parallel tangential lines which form locally a Cartesian grid in order to perform subsampling like SENSE or SMASH. If the whole k-space is subdivided by rays divided homogeneously over an angle of 360° a continuous system of local Cartesian grids is obtained. These parts of k-space are than locally reconstructed and converted as a whole to an image.

This and other advantages of the invention are disclosed in the dependent claims and in the following description in which an exemplified embodiment of the invention is described with respect to the accompanying drawings. Therein shows:

Fig. 1 an undersampled spiral trajectory in k-space,
Fig. 2 the same spiral trajectory as in Fig. 1 with hypothetical parallel scan lines for a region around the radius with an angle θ,
Fig. 3 folding points in the image corresponding to a hypothetical Cartesian sampling pattern as shown in Fig. 2,
Fig. 4 an apparatus for carrying out the method in accordance with the present invention, and
Fig. 5 a circuit diagram of the apparatus as shown in Fig. 4.

Basis of the present invention

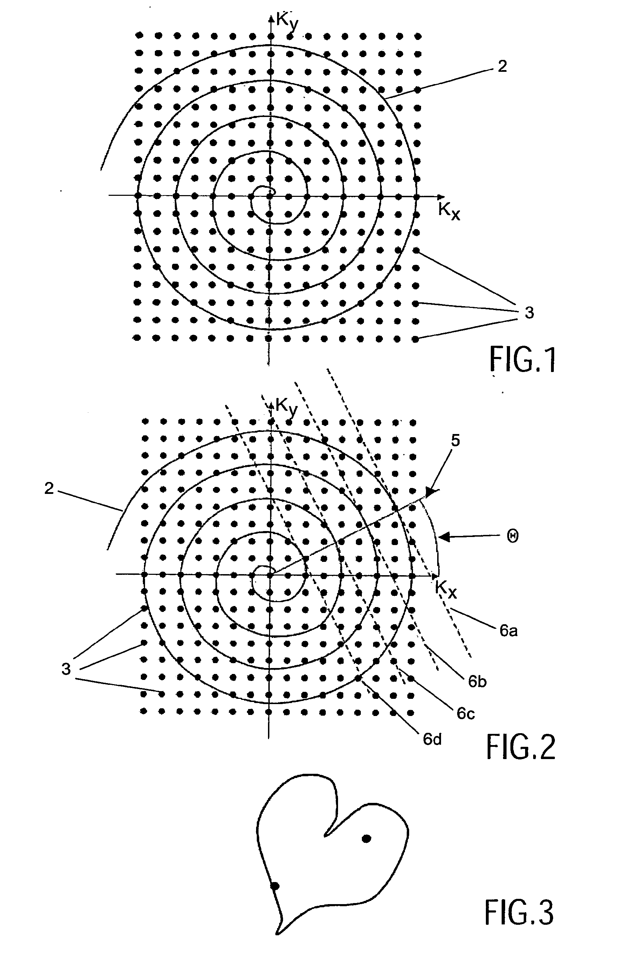

In Fig. 1 a spiral scan trajectory has been depicted, which is a single spiral arm 2 in single shot EPI. The dots 3 represent a Cartesian grid of a density that would be required to properly image the Field-of-View (FOV) encompassing the object to be imaged. The actual density may also be slightly higher (so called "overgridding"), corresponding to a region that is slightly larger than the object. The spiral arm 2 has been grossly undersampled according to the SENSE method with an undersampling factor of about two. This can immediately be seen from Fig. 1 as the distance between the spiral parts of the arm is at about a distance of two dots 3. From the point of view of the Nyquist criterion this is insufficient sampling. However, if the signal of that trajectory has been sampled by at least two receiver antennae or coils having different spatial-sensitivity patterns, the image can be reconstructed nevertheless. The reconstruction of the image requires the solution of a set of approximately N equations with N unknowns, where N is of the order of magnitude of the number of sample points times the number of coils, or of the order of the number of pixels in the resulting image (i.e., N is about $10^4$ to $10^5$). This means that a number of N equations should be solved, which is not feasible by direct matrix inversion. Therefore, an iterative solution is proposed by several authors, which requires about ten iterations, each involving expensive computational gridding operations.

Outline of the algorithm according to the present invention

In Figure 2 in the spiral arm 2 a radial line 5 with an angle 9 is depicted, which traverses the spiral arm 2. At the crossing points between the radial line 5 and the spiral arm 2 tangential lines 6a, 6b, 6c and 6d are drawn, which show that the neighboring parts of spiral arm 2 are more or less parallel and equidistant. At present an Archimedic spiral is shown, but also other spiral functions may be used. This situation is well known form the Cartesian approach in parallel imaging: if these equidistant lines 6a to 6b would have covered the whole k-space, then reconstruction would be much less laborious. In image space a discrete number of object-points would "simply" be folded onto each other, as shown just for simplicity with two points in Figure 3.

In principle, the problem can be solved then by "normal" SENSE reconstruction. This can be written as sum of receiver antenna signals $m_k(X,Y)$ "weighted" to a function $a_k(X,Y)$. This can also be written in the Fourier-domain as

$$p(X,Y) = \sum_{coils\ k} F^{-1}\{\alpha_k(k_x,k_y) \otimes \mu_k(k_x,k_y)\}\ ,\ \text{or} \tag{1}$$

$$p(X,Y) = F^{-1}\{\sum_{coils\ k} \alpha_k(k_x,k_y) \otimes \mu_k(k_x,k_y)\} \tag{2}$$

with $\mu_k(k_x,k_y)$ the measured data along the hypothetical equidistant lines 6a to 6b, with $\alpha$ the Fourier transform of $a_k(X,Y)$.

It is noted that equations (1) or (2) describe exactly the same operations performed for normal spiral imaging without undersampling (SENSE, SMASH). There, the meaning of $\alpha_k(X,Y)$ is the "gridding kernel", which is in essence the Fourier transform of a box (but tapered with smooth edges to prevent that $\alpha_k(X,Y)$ having a large support).

In the present case, the shape of $\alpha_k(X,Y)$ is not a tapered box, but a "reconstructing function", which depends essentially on the coil sensitivity pattern of all receiver antennae or coils, on the folding distance of the SENSE method and eventually partly on the object shape (due to regularization). Yet, since the coil sensitivity functions are expected to be smooth functions in space, the functions $a_k(X,Y)$ are also expected to be smooth in space. For that reason, the gridding function $\alpha_k(k_x,k_y)$ is expected to have a relatively small support. It is supposed that a support of 12 * 12 to 16 * 16 Cartesian points will be sufficient (where for gridding of normal imaging a support of 4 * 4 is usually enough).

The obtained gridding function $\alpha_k(k_x,k_y)$ can be applied perfectly to reconstruct data from a set of parallel equidistant lines that are angulated with respect to the required grid. However, in this case the data is sampled along a spiral arm, and not along a line. That means that the obtained gridding kernel is only valid for points that are strictly positioned on the radius with an angle $\theta$. Strictly the gridding kernel $\alpha_k(X,Y)$ should be calculated for an infinity of situations. Yet, coil sensitivity patterns are normally smooth functions of space. This means that the weighting function $\alpha_k(X,Y)$ (and consequently the gridding function $\alpha_k(k_x,k_y)$) will not alter significantly if the folding direction is slightly changed. The "folding direction" is defined by the angle between the line of the folding points, or, equivalently, by the orientation of the hypothetical parallel lines 6a to 6d. For that reason, the obtained gridding function can be applied in a predetermined region around the radius with angle $\theta$. This allows to calculate $\alpha_k(k_x,k_y)$ for a limited number of radii (e.g. 10 or 20).

Resulting algorithm

It is assumed that coil sensitivities are known in the entire relevant region, and that there is some knowledge on the presence of the object (as in Cartesian SENSE). Given is a spiral trajectory in two-dimensional k-space. The only relevant issue is then the distance between the spiral arms. Reconstruction according to the present invention will be performed by following steps:

1. A Cartesian grid is chosen. The distance (or density) should correspond to the size of the object under study.
2. A number of equidistant radii over the k-space is defined (e.g. 10 or 20).
3. For each radius, the direction of the lines 6a to 6b tangential to the spiral arms is determined, whereas the distance between the tangential lines should be independent of the angle.
4. For the obtained set of folding points, the SENSE reconstruction matrix $A = (S^h \cdot \Psi^{-1} \cdot S + R^{-1})^{-1} \cdot S^h \cdot \Psi^{-1}$ is calculated, wherein S is the receiver antenna or coil sensitivity matrix, $\Psi$ is the noise covariance between the coil channels, R is the regularization matrix and $S^h$ means the hermitian conjugate of S. The segments of the matrix A are combined into the function $\alpha_k(X,Y)$ for each receiver antenna or coil k. (It is noted that this step is part of the normal SENSE reconstruction.)
5. Outside of the image area, the function $\alpha_k(X,Y)$ is set to zero (zero-padding); a Fourier transformation of this function is then performed into $\alpha_k(k_x,k_y)$, or any other suitable method to interpolate values of $\alpha_k(k_x,k_y)$ on a sufficiently fine grid for the subsequent convolution and resampling is used. This function is expected to be relevant only for small values of $k_x$ and ky, so that the outer parts thereof can be discarded.
6. The data is acquired.
7. The sampling density compensation is performed.
8. For each point along the spiral trajectory, the radius that comes closest to that sample point is determined

9. Using the gridding function $\alpha_k(k_x,k_y)$ calculated for the closest radius of each coil, and the acquired data sample of each coil, a gridding operation is performed. This operation is part of the normal spiral scan reconstruction procedure, only the extent of $\alpha_k$ may be larger.
10. The data is summed over the coil elements.
11. The Cartesian grid points are Fourier-transformed.

It is noted that for dynamic scans (or any type of scans in which a multitude of data sets for the same geometric positions is acquired), steps 1 to 5 have to done only once.

Refinements of the algorithm

R1. A grid can be chosen which does not correspond to the normal FOV (or "the size of the object under study") but to a slightly larger FOV, and thus being slightly denser. The margins between the user selected FOV and the larger or "overgridded" FOV are known to contain no object. Towards the edge of the overgridded FOV, the regularization values R are gradually forced to zero. In such a manner, discontinuities of the functions $a_k(X,Y)$ are avoided, leading to a smaller support of $\alpha_k(k_x,k_y)$.

R2. The functions $a_k(X,Y)$ can be preconditioned by first multiplying them with a common shaping function, in order to reduce the support of $\alpha_k(k_x,k_y)$. This may be a tapering window function, or a multiplication by e.g. the sum of squares of sensitivities, to prevent huge values on points in space where all coils are insensitive.

R3. The two nearest radii can be taken and the gridding kernel functions between them can be interpolated. In a more efficient way, both radii are gridded and the result thereof is interpolated.

R4. The most central region of k-space can be reconstructed by another method (e.g. direct inversion) and the gridding result is blended with the alternative reconstruction of the central region.

R5. The functions $a_k(X,Y)$ are divided into a defined number of subfunctions, for which the support of the corresponding $\tilde{\alpha}_k(k_x,k_y)$ is particularly small, and the sum of which equals or approximates the original $a_k(X,Y)$ in the full Field-of-View. This allows to cope with sharp transitions in $a_k(X,Y)$, which most notably occur at the edges of the reduced Field-of-Views. A separate gridding for each set of subfunctions is required in this case. Compared with expanding the size of the local convolution kernel adequately to represent sharp transitions, this may be computationally attractive. One natural choice would be to take each reduced Field-of-View separately, and treat the function - with or without periodic replication - with some sort of tapering window function.

R6. For a similar reason, sets of samples assigned to adjacent radii can be separately gridded and transformed. This allows to provide "space" for errors with the full FOV, very much like the conventional oversampling provides "space" for errors at the edges of the full FOV.

R7. The proposed algorithm may be used to generate an image with which one of the known iterative reconstruction algorithms (e.g. the conjugate gradient method) is then initialized. This allows to substantially reduce the number of iterations required by these methods to achieve an adequate image quality. Equally, this strategy permits to eliminate any artifacts potentially remaining with the proposed algorithm for reasonable parameter settings (i.e. limited support of $\alpha_k(k_x,k_y)$ and limited number of radii).

Extension of the method

In principle, the local neighborhood of each k-space sampling point and the local degree of subsampling may be considered separately. In this case, steps 1 to 5 of the method according to the present invention would be performed for sets of points with similar local properties, which may be arbitrarily distributed in k-space. This would allow to apply the proposed algorithm also to, among others, variable density spiral and conventional radial acquisitions.

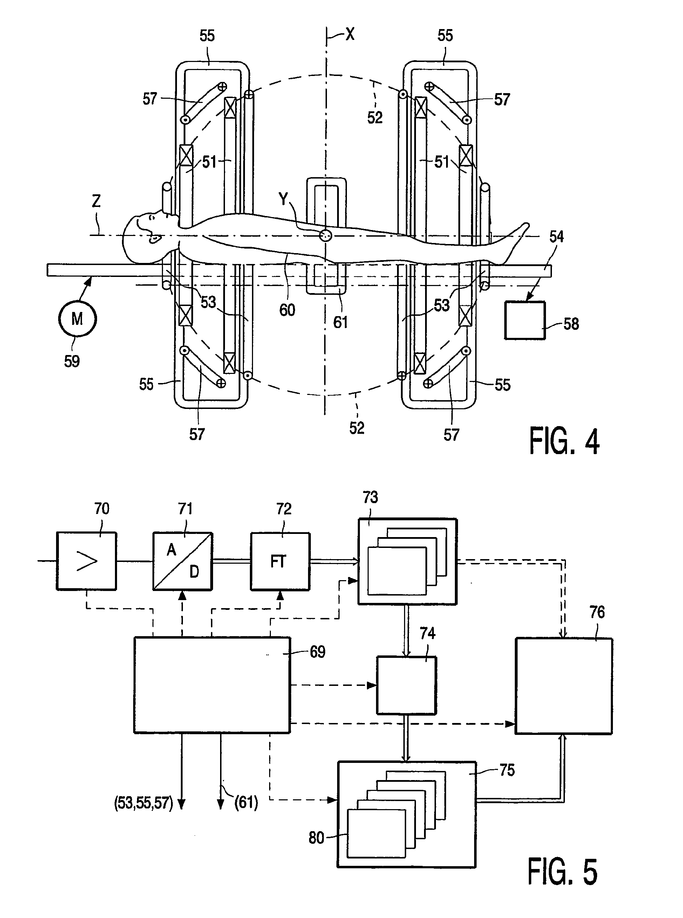

The apparatus shown in Fig. 4 is an MR apparatus which comprises a system of four coils 51 for generating a steady, uniform magnetic field whose strength is of the order of magnitude of from some tenths of Tesla to some Tesla. The coils 51, being concentrically arranged relative to the z axis, may be provided on a spherical surface 52. The patient 60 to be examined is arranged on a table 54 which is positioned inside these coils. In order to produce a magnetic field which extends in the z direction and linearly varies in this direction (which field is also referred to hereinafter as the gradient field), four coils 53 as multiple receiver antennae are provided on the spherical surface 52. Also present are four coils 57 which generate a gradient field which also extends (vertically) in the x direction. A magnetic gradient field extending in the z direction and having a gradient in the y direction (perpendicularly to the plane of the drawing) is generated by four coils 55 which may be identical to the coils 57 but are arranged so as to be offset 90° in space with respect thereto. Only two of these four coils are shown here.

Because each of the three coil systems 53, 55, and 57 for generating the magnetic gradient fields is symmetrically arranged relative to the spherical surface, the field strength at the center of the sphere is determined exclusively by the steady, uniform magnetic field of the coil 51. Also provided is an RF coil 61 which generates an essentially uniform RF magnetic field which extends perpendicularly to the direction of the steady, uniform magnetic field (i.e. perpendicularly to the z direction). The RF coil receives an RF modulated current from an RF generator during each RF pulse The RF coil 61 can also be used for receiving the spin resonance signals generated in the examination zone.

As is shown in Figure 5 the MR signals received in the MR apparatus are amplified by a unit 70 and transposed in the baseband. The analog signal thus obtained is converted into a sequence of digital values by an analog-to-digital converter 71. The analog-to-digital converter 71 is controlled by a control unit 69 so that it generates digital data words only during the read-out phase. The analog-to-digital converter 71 is succeeded by a Fourier transformation unit 72 which performs a one-dimensional Fourier transformation over the sequence of sampling values obtained by digitization of an MR signal, execution being so fast that the Fourier transformation is terminated before the next MR signal is received.

The raw data thus produced by Fourier transformation is written into a memory 73 whose storage capacity suffices for the storage of several sets of raw data. From these sets of raw data a composition unit 74 generates a composite image in the described manner; this composite image is stored in a memory 75 whose storage capacity suffices for the storage of a large number of successive composite images 80. These sets of data are calculated for different instants, the spacing of which is preferably small in comparison with the measurement period required for the acquisition of a set of data. A reconstruction unit 76, performing a composition of the successive images, produces MR images from the sets of data thus acquired, said MR images being stored. The MR images represent the examination zone at the predetermined instants. The series of the MR images thus obtained from the data suitably reproduces the dynamic processes in the examination zone.

The units 70 to 76 are controlled by the control unit 69. As denoted by the down wards pointing arrows, the control unit also imposes the variation in time of the currents in the gradient coil systems 53, 55 and 57 as well as the central frequency, the bandwidth and the envelope of the RF pulses generated by the RF coil 61. The memories 73 and 75 as well as the MR image memory (not shown) in the reconstruction unit 76 can be realized by way of a single memory of adequate capacity. The Fourier transformation unit 72, the composition unit 74 and the reconstruction unit 76 can be realized by way of a data processor well-suited for running a computer program according the above mentioned method.

## Claims

1. A magnetic resonance imaging method comprising the steps of:

   acquiring, with undersampling, magnetic resonance signals by means of a receiver antennae system via a plurality of signal channels, which receiver antennae system has a sensitivity profile,
   regularly re-sampling magnetic resonance signals on a regular sampling grid from the undersampled acquired magnetic resonance signals, the re-sampling involving convolution of the undersampled acquired magnetic resonance signals with a gridding kernel depending on the sensitivity profile of the receiver antennae system, and reconstructing a magnetic resonance image from the re-sampled magnetic resonance signals, **characterized in that**
   the resampling is carried out for respective orientated sector shaped regions in k-space that extend between angular boundaries, between a respective minimum and maximum modulus of a k-vector to the periphery of k-space and bounded by radial boundaries that extend radially from the origin of k-space, and
   the gridding kernel also depends on the orientation of the sector shaped region at issue.

2. A magnetic resonance imaging method as claimed in Claim 1, wherein the magnetic resonance signals are acquired by scanning k-space along a non-linear, in particular spiral shaped, trajectory.

3. A magnetic resonance imaging method as claimed in Claim 1 for forming an image of an object wherein

   - a magnetic resonance image is derived from sub-sampled magnetic resonance signals and on the basis of the spatial sensitivity profiles of a plurality of receiving antennae,
   - a sequence of RF-pulses and gradients is applied, which sequence corresponds to a set of trajectories comprising at least one substantially non-linear trajectory in k-space, wherein the sampling density of said trajectory set being substantially lower than the normal sampling density corresponding to the object size,
   - each signal along said trajectory set is sampled at least at two different receiver antenna positions, resulting into a plurality of receiver-antenna signals,
   - the image is reconstructed by converting the data of said signals from said trajectory set to a Cartesian grid by convolution with a gridding kernel,

and wherein

- the gridding kernel is a Fourier-transform of a pattern weighted for each antenna with respect to the Cartesian grid, and
- the gridding kernel pattern differs between one region and another in k-space.

4. A method as claimed in claim 1, wherein the weighting pattern is obtained in that

- to every individual region of k-space, a set of parallel equidistant lines is assigned, which lines locally match said trajectory set,
- a pattern of overlapping points in image space is determined, which corresponds to the set of parallel equidistant lines in k-space,
- in image space, the weighting pattern per antenna is calculated, which pattern approximately corresponds to a pattern solely of said parallel equidistant lines in the individual region of k-space.

5. A method as claimed in claim 2, wherein at least part of the trajectory set corresponds to an Archimedic spiral and the regions in k-space are defined by their azimuthal angle in k-space.

6. A method as claimed in claim 4 or 5, wherein the weighting pattern of the antenna is calculated according to the inversion of a Cartesian set of equations for the subsampled data and the spatial sensitivity profiles of the receiving antennae.

7. A method as claimed in claim 6, wherein the inversion of said Cartesian set of equations is formulated as $A = (S^h \cdot \Psi^{-1} \cdot S + R^{-1})^{-1} \cdot S^h \cdot \Psi^{-1}$, wherein A is the reconstruction matrix, S is the receiver antenna sensitivity matrix $(s_{ij})$, wherein $s_{ij}$ is the spatial sensitivity profile of antenna i on the j-th point of the overlapping set of points, $\Psi$ is the noise covariance between the antennae, R is the regularization matrix and $S^h$ means the hermitian conjugate of S.

8. A method as claimed in claim 7, wherein the gridding kernel is chosen to correspond to a larger FOV than a normal FOV covering the size of the object to be studied, and the values of the regularization matrix R between the margin of the larger FOV and the normal FOV are set to zero.

9. A method as claimed in claim 8, wherein the gridding kernel pattern for each antenna derived from the reconstruction matrix A is multiplied with a common shaping function comprising a tapering window function or the sum of squares of sensitivities of each antenna.

10. A method as claimed in one of claims 5 to 9, wherein the gridding kernel functions between the two nearest radii traversing the spiral trajectory set are interpolated.

11. A method as claimed in claim 10, wherein both radii are gridded and the result thereof is interpolated.

12. A method as claimed in one of claims 1 to 11, wherein the most central region of k-space is reconstructed at full sampling density by direct inversion and the result of the gridding reconstruction method is blended with the result of the reconstruction at full sampling density.

13. A method as claimed in one of claims 7 to 12, wherein the gridding kernel pattern for each antenna derived from the reconstruction matrix A is divided into a defined number of subfunctions, for which the support of the corresponding functions in k-space tends to zero, in order to discard sharp transitions in the gridding kernel pattern, whereas each subfunction is gridded separately.

14. A method as claimed in claim 10, wherein sets of samples assigned to adjacent radii are gridded and transformed separately.

15. Use of the image generated by the method as claimed in one of claims 1 to 14, in order to initialize a conventional iterative algorithm for reconstruction of the image.

16. A magnetic resonance imaging apparatus for obtaining an MR image from a plurality of signals, the magnetic resonance imaging apparatus comprising:

- a main magnet (51),
- a transmitter antenna (53, 61) for excitation of spins in a predetermined area of the patient,
- a plurality of receiver antennae (53, 61) for sampling signals in a restricted homogeneity region of the main magnet field,
- a table (54) for bearing a patient,
- means (59) for continuously moving the table through the bore of the main magnet,
- means (69-76) for deriving a magnetic resonance image from sub-sampled magnetic resonance signals and on the basis of the spatial sensitivity profile of each of said receiving antenna positions,
- means (69, 53, 61) for applying a sequence of RF-pulses and gradients, which sequence corresponds to a set of trajectories comprising at least one substantially non-linear trajectory in k-space, wherein the density of said trajectory set is substantially lower than the density corresponding to the object size,
- means (70, 71) for sampling each signal along said trajectory set at least at two different receiver antenna positions, resulting into a plurality of receiver-antenna signals,
- means (76) for reconstructing the image by converting the data of said signals from said trajectory set to a Cartesian grid by convolution with a gridding kernel,

**characterized in that**
said reconstructing means (76) are arranged for converting the data to a Cartesian grid for respective orientated sector shaped regions in k-space that extend between angular boundaries, between a respective minimum and maximum modulus of a k-vector to the periphery of k-space and bounded by radial boundaries that extend radially from the origin of k-space,
the gridding kernel is specific for each antenna and also depends on the orientation of the sector shaped region at issue,
the gridding kernel pattern differs between one region and another in k-space, and
the gridding kernel is a Fourier-transform of a pattern weighted for each antenna with respect to the Cartesian grid.

17. Apparatus according to claim 16, further comprising

    - means (69) for obtaining the weighting pattern including
    - means for assigning, to every individual region of k-space, a set of parallel equidistant lines, which lines locally match said trajectory set,
    - means (69) for determining a pattern of overlapping points in image space, which corresponds to the set of parallel equidistant lines in k-space, and
    - means (69) for calculating, in image space, the weighting pattern per antenna, which pattern approximately corresponds to a pattern solely of said parallel equidistant lines in the individual region of k-space.

18. Apparatus as claimed in claim 17, further comprising means (69) for defining the regions in k-space by their azimuthal angle in k-space, whereas at least part of the trajectory set corresponds to equidistant spirals.

19. Apparatus method as claimed in claim 17 or 18, further comprising means (69, 76) for calculating the weighting pattern of the antenna according to the inversion of a Cartesian set of equations for the subsampled data and the spatial sensitivity profiles of the receiving antennae.

20. Apparatus as claimed in claim 19, whereas said means (69, 76) for calculating the inversion of said Cartesian set of equations is based on formula $A = (S^h \cdot \Psi^{-1} \cdot S + R^{-1})^{-1} \cdot S^h \cdot \Psi^{-1}$, wherein A is the reconstruction matrix, S is the receiver antenna sensitivity matrix ($s_{ij}$), wherein $s_{ij}$ is the spatial sensitivity profile of antenna i on the j-th point of the overlapping set of points, $\Psi$ is the noise covariance between the antennae, R is the regularization matrix and $S^h$ means the hermitian conjugate of S.

21. A computer program product stored on a computer usable medium for forming an image by means of the magnetic resonance method, comprising a computer readable program means for causing the computer to control the execution of:

    - creating a main magnetic field by a main magnet,
    - excitation of spins in a predetermined area of the patient by a transmitter antenna,
    - sampling a plurality of signals in a restricted homogeneity region of the main magnet field at a plurality of receiver antenna positions,
    - continuously moving a table bearing a patient through the bore of the main magnet,

- deriving a magnetic resonance image from sub-sampled magnetic resonance signals and on the basis of the spatial sensitivity profile of each of said receiving antenna positions,
- applying a sequence of RF-pulses and gradients, which sequence corresponds to a set of trajectories containing at least one substantially non-linear trajectory in k-space, wherein the density of said trajectory set is substantially lower than the density corresponding to the object size,
- sampling each signal along said trajectory set at least at two different receiver antenna positions, resulting into a plurality of receiver-antenna signals,
- reconstructing the image by converting the data of said signals from said trajectory set to a Cartesian grid by convolution with a gridding kernel,

**characterized in that**

the data are converted to a Cartesian grid for respective orientated sector shaped regions in k-space that extend between angular boundaries, between a respective minimum and maximum modulus of a k-vector to the periphery of k-space and bounded by radial boundaries that extend radially from the origin of k-space,
the gridding kernel is specific for each antenna and also depends on the orientation of the sector shaped region at issue,
the gridding kernel pattern differs between one region and another in k-space, and
the gridding kernel is a Fourier-transform of a pattern weighted for each antenna with respect to the Cartesian grid.

**Patentansprüche**

1. Magnetresonanzbildgebungsverfahren, das die folgenden Schritte umfasst:

   mit Unterabtastung Erfassen von Magnetresonanzsignalen mit Hilfe eines Empfangsantennensystems über eine Vielzahl von Signalkanälen, wobei das Empfangsantennensystem ein Empfindlichkeitsprofil hat,
   regelmäßiges erneutes Abtasten der Magnetresonanzsignale auf einem regelmäßigen Abtastgitter von den mit Unterabtastung erfassten Magnetresonanzsignalen, wobei die erneute Abtastung die Faltung der mit Unterabtastung erfassten Magnetresonanzsignale mit einem Gridding Kernel umfasst, der von dem Empfindlichkeitsprofil des Empfangsantennensystems abhängt, und
   Rekonstruieren eines Magnetresonanzbildes anhand der erneut abgetasteten Magnetresonanzsignale, **dadurch gekennzeichnet, dass**
   die erneute Abtastung für jeweilige orientierte sektorförmige Regionen im k-Raum ausgeführt wird, die sich zwischen Winkelgrenzen, zwischen einem jeweiligen Minimum- und Maximummodulus eines k-Vektors von der Peripherie des k-Raums erstrecken und durch radiale Grenzen begrenzt sind, die sich radial vom Ursprung des k-Raums erstrecken, und
   der Gridding Kernel auch von der Orientierung der betreffenden sektorförmigen Region abhängt.

2. Magnetresonanzbildgebungsverfahren nach Anspruch 1, wobei die Magnetresonanzsignale erfasst werden, indem der k-Raum entlang einer nicht-linearen, insbesondere spiralförmigen Trajektorie gescannt wird.

3. Magnetresonanzbildgebungsverfahren nach Anspruch 1 zum Erstellen eines Bildes eines Objekts, wobei

   - ein Magnetresonanzbild von unterabgetasteten Magnetresonanzsignalen und auf der Basis der räumlichen Empfindlichkeitsprofile einer Vielzahl von Empfangsantennen abgeleitet wird,
   - eine Sequenz von HF-Impulsen und Gradienten angelegt wird, die einer Gruppe von Trajektorien entspricht, welche mindestens eine im Wesentlichen nicht-lineare Trajektorie im k-Raum umfasst, wobei die Abtastdichte der genannten Trajektoriengruppe deutlich geringer ist als die normale, der Objektgröße entsprechende Abtastdichte,
   - jedes Signal entlang der genannten Trajektoriengruppe mindestens bei zwei verschiedenen Empfangsantennenpositionen abgetastet wird, so dass sich eine Vielzahl von Empfangsantennensignalen ergibt,
   - das Bild rekonstruiert wird, indem die Daten der genannten Signale von der genannten Trajektoriengruppe durch Faltung mit einem Gridding Kernel in ein kartesisches Gitter umgewandelt werden, und wobei
   - der Gridding Kernel eine Fourier-Transformation eines für jede Antenne in Bezug auf das kartesische Gitter gewichteten Musters ist, und
   - das Gridding-Kernel-Muster von Region zu Region im k-Raum unterschiedlich ist.

4. Verfahren nach Anspruch 1, wobei das Gewichtungsmuster erlangt wird, indem

- jeder einzelnen Region des k-Raums eine Gruppe von parallelen, äquidistanten Linien zugewiesen wird, die lokal mit der genannten Trajektoriengruppe übereinstimmen,
- ein Muster von überlappenden Punkten im Bildraum bestimmt wird, das der Gruppe von parallelen, äquidistanten Linien im k-Raum entspricht,
- im Bildraum das Gewichtungsmuster pro Antenne berechnet wird, wobei das Muster annähernd einem Muster ausschließlich aus den genannten parallelen äquidistanten Linien in der einzelnen Region des k-Raums entspricht.

5. Verfahren nach Anspruch 2, wobei mindestens ein Teil der Trajektoriengruppe einer archimedischen Spirale entspricht und die Regionen im k-Raum durch ihren Azimuthwinkel im k-Raum definiert werden.

6. Verfahren nach Anspruch 4 oder 5, wobei das Gewichtungsmuster der Antenne entsprechend der Invertierung eines kartesischen Gleichungssatzes für die unterabgetasteten Daten und der räumlichen Empfindlichkeitsprofile der Empfangsantennen berechnet wird.

7. Verfahren nach Anspruch 6, wobei die Invertierung des genannten kartesischen Gleichungssatzes formuliert wird als $A = (S^h \cdot \Psi^{-1} \cdot S + R^{-1})^{-1} \cdot S^h \cdot \Psi^{-1}$, wobei A die Rekonstruktionsmatrix ist, S die Empfangsantennenempfindlichkeitsmatrix ($s_{ij}$), wobei $s_{ij}$ das räumliche Empfindlichkeitsprofil der Antenne i am j-ten Punkt der überlappenden Gruppe von Punkten ist, $\psi$ die Rauschkovarianz zwischen den Antennen ist, R die Regularisierungsmatrix ist und $S^h$ die hermitesche Konjugierte von S ist.

8. Verfahren nach Anspruch 7, wobei der Gridding Kernel so gewählt wird, dass er einem größeren Sichtfeld (engl. field of view, FOV) als einem normalen Sichtfeld entspricht, das die Größe des zu untersuchenden Objekts abdeckt, und die Werte der Regularisierungsmatrix R zwischen dem Rand des größeren Sichtfelds und dem normalen Sichtfeld auf Null gesetzt werden.

9. Verfahren nach Anspruch 8, wobei das Gridding-Kemel-Muster für jede Antenne, das von der Rekonstruktionsmatrix A abgeleitet wurde, mit einer gemeinsamen Formungsfunktion multipliziert wird, die eine sich verschmälernde Fensterfunktion oder die Summe der Empfindlichkeitsquadrate jeder Antenne umfasst.

10. Verfahren nach einem der Ansprüche 5 bis 9, wobei die Gridding-Kemel-Funktionen zwischen den beiden nächstgelegenen Radien, die die Spiraltrajektoriengruppe durchqueren, interpoliert werden.

11. Verfahren nach Anspruch 10, wobei beide Radien einem Gridding unterzogen werden und das Resultat interpoliert wird.

12. Verfahren nach einem der Ansprüche 1 bis 11, wobei die zentralste Region des k-Raums durch direkter Invertierung mit voller Abtastdichte rekonstruiert wird und das Ergebnis des Gridding-Rekonstruktionsverfahren mit dem Ergebnis der Rekonstruktion mit voller Abtastdichte zusammengeführt wird.

13. Verfahren nach einem der Ansprüche 7 bis 12, wobei das von der Rekonstruktionsmatrix A abgeleitete Gridding-Kernel-Muster für jede Antenne in eine definierte Anzahl von Subfunktionen aufgeteilt wird, für die die Unterstützung der entsprechenden Funktionen im k-Raum zu Null tendiert, um scharfe Übergänge im Gridding-Kemel-Muster zu beseitigen, während jede Subfunktion separat einem Gridding unterzogen wird.

14. Verfahren nach Anspruch 10, wobei Sätze von Abtastwerten, die benachbarten Radien zugewiesen sind, separat einem Gridding unterzogen und transformiert werden.

15. Nutzung des durch das Verfahren nach einem der Ansprüche 1 bis 14 erzeugten Bildes, um einen herkömmlichen iterativen Algorithmus zur Rekonstruktion des Bildes zu initialisieren.

16. Magnetresonanzbildgebungsgerät zum Erlangen eines MR-Bildes aus einer Vielzahl von Signalen, wobei das Magnetresonanzbildgebungsgerät Folgendes umfasst:

- einen Hauptmagneten (51),
- eine Sendeantenne (53, 61) zur Anregung von Spins in einem vorgegebenen Bereich des Patienten,
- eine Vielzahl von Empfangsantennen (53, 61) zum Abtasten von Signalen in einer begrenzten Homogenitätsregion des Hauptmagnetfelds,

- eine Liege (54) zum Tragen eines Patienten,

- Mittel (59) zum kontinuierlichen Bewegen der Liege durch die Röhrenöffnung des Hauptmagneten,

- Mittel (69-76) zum Ableiten eines Magnetresonanzbildes von unterabgetasteten Magnetresonanzsignalen und auf der Basis des räumlichen Empfindlichkeitsprofils von jeder der genannten Empfangsantennenpositionen,

- Mittel (69, 53, 61) zum Anlegen einer Sequenz von HF-Impulsen und Gradienten, wobei die Sequenz einer Trajektoriengruppe entspricht, die mindestens eine im Wesentlichen nicht-lineare Trajektorie im k-Raum umfasst, wobei die Dichte der genannten Trajektoriengruppe deutlich geringer ist als die der Objektgröße entsprechende Dichte,

- Mittel (70, 71) zum Abtasten jedes Signals entlang der genannten Trajektoriengruppe mindestens bei zwei verschiedenen Empfangsantennenpositionen, so dass sich eine Vielzahl von Empfangsantennensignalen ergibt,

- Mittel (76) zum Rekonstruieren des Bildes, indem die Daten der genannten Signale von der genannten Trajektoriengruppe durch Faltung mit einem Gridding Kernel in ein kartesisches Gitter umgewandelt werden,

**dadurch gekennzeichnet, dass**

die genannten Rekonstruktionsmittel (76) dafür ausgelegt sind, die Daten in ein kartesisches Gitter für jeweilige orientierte sektorförmige Regionen im k-Raum umzuwandeln, die sich zwischen Winkelgrenzen, zwischen einem jeweiligen Minimum- und Maximummodulus eines k-Vektors zur Peripherie des k-Raums erstrecken und durch radiale Grenzen begrenzt sind, die sich radial vom Ursprung des k-Raums erstrecken,

der Gridding Kernel für jede Antenne spezifisch ist und auch von der Orientierung der betreffenden sektorförmigen Region abhängt,

das Gridding-Kernel-Muster von Region zu Region im k-Raum unterschiedlich ist, und

der Gridding Kernel eine Fourier-Transformation eines für jede Antenne in Bezug auf das kartesische Gitter gewichteten Musters ist.

17. Gerät nach Anspruch 16, das weiterhin Folgendes umfasst:

- Mittel (69) zum Erlangen des Gewichtungsmusters mit

- Mitteln, um jeder einzelnen Region des k-Raums eine Gruppe von parallelen, äquidistanten Linien zuzuweisen, die lokal mit der genannten Trajektoriengruppe übereinstimmen,

- Mittel (69), um ein Muster von überlappenden Punkten im Bildraum zu bestimmen, das der Gruppe von parallelen, äquidistanten Linien im k-Raum entspricht, und

- Mittel (69), um im Bildraum das Gewichtungsmuster pro Antenne zu berechnen, wobei das Muster annähernd einem Muster ausschließlich aus den genannten parallelen äquidistanten Linien in der einzelnen Region des k-Raums entspricht.

18. Gerät nach Anspruch 17, das weiterhin Mittel (69) zum Definieren der Regionen im k-Raum durch ihren Azimuthwinkel im k-Raum umfasst, wobei mindestens ein Teil der Trajektoriengruppe äquidistanten Spiralen entspricht.

19. Gerät nach Anspruch 17 oder 18, weiterhin mit Mitteln (69, 76) zum Berechnen des Gewichtungsmusters der Antenne entsprechend der Invertierung eines kartesischen Gleichungssatzes für die unterabgetasteten Daten und der räumlichen Empfindlichkeitsprofile der Empfangsantennen.

20. Gerät nach Anspruch 19, wobei die genannten Mittel (69, 76) zum Berechnen der Invertierung des genannten kartesischen Gleichungssatzes auf der Formel $A = (S^h \cdot \Psi^{-1} \cdot S + R^{-1})^{-1} \cdot S^h \cdot \Psi^{-1}$ basiert, wobei A die Rekonstruktionsmatrix ist, S die Empfangsantennenempfindlichkeitsmatrix ($s_{ij}$), wobei $s_{ij}$ das räumliche Empfindlichkeitsprofil der Antenne i am j-ten Punkt der überlappenden Gruppe von Punkten ist, $\psi$ die Rauschkovarianz zwischen den Antennen ist, R die Regularisierungsmatrix ist und $S^h$ die hermitesche Konjugierte von S ist.

21. Auf einem computerlesbaren Medium gespeichertes Computerprogrammprodukt zum Erzeugen eines Bildes mit Hilfe des Magnetresonanzverfahrens, mit einem computerlesbaren Programmmittel zum Veranlassen des Computers, die Ausführung der folgenden Schritte zu steuern:

- Erzeugen eines Hauptmagnetfelds durch dienen Hauptmagneten,

- Anregung von Spins in einem vorgegebenen Bereich des Patienten durch eine Sendeantenne,

- Abtasten einer Vielzahl von Signalen in einer begrenzten Homogenitätsregion des Hauptmagnetfelds bei einer Vielzahl von Empfangsantennenpositionen,

EP 1 716 430 B1

- kontinuierliches Bewegen einer einen Patienten tragenden Liege durch die Röhrenöffnung des Hauptmagneten,
- Ableiten eines Magnetresonanzbildes von unterabgetasteten Magnetresonanzsignalen und auf der Basis des räumlichen Empfindlichkeitsprofils von jeder der genannten Empfangsantennenpositionen,
- Anlegen einer Sequenz von HF-Impulsen und Gradienten, wobei die Sequenz einer Trajektoriengruppe entspricht, die mindestens eine im Wesentlichen nicht-lineare Trajektorie im k-Raum umfasst, wobei die Dichte der genannten Trajektorie deutlich geringer ist als die der Objektgröße entsprechende Dichte,
- Abtasten jedes Signals entlang der genannten Trajektoriegruppe mindestens bei zwei verschiedenen Empfangsantennenpositionen, so dass sich eine Vielzahl von Empfangsantennensignalen ergibt,
- Rekonstruieren des Bildes, indem die Daten der genannten Signale von der genannten Trajektoriengruppe durch Faltung mit einem Gridding Kernel in ein kartesisches Gitter umgewandelt werden,

**dadurch gekennzeichnet, dass**
die Daten in ein kartesisches Gitter für jeweilige orientierte sektorförmige Regionen im k-Raum umgewandelt werden, die sich zwischen Winkelgrenzen, zwischen einem jeweiligen Minimum- und Maximummodulus eines k-Vektors zur Peripherie des k-Raums erstrecken und durch radiale Grenzen begrenzt sind, die sich radial vom Ursprung des k-Raums erstrecken,
der Gridding Kernel für jede Antenne spezifisch ist und auch von der Orientierung der betreffenden sektorförmigen Region abhängt,
das Gridding-Kemel-Muster von Region zu Region im k-Raum unterschiedlich ist, und
der Gridding Kernel eine Fourier-Transformation eines für jede Antenne in Bezug auf das kartesische Gitter gewichteten Musters ist.

**Revendications**

1. Procédé d'imagerie par résonance magnétique comprenant les étapes suivantes consistant à:

    acquérir, par sous-échantillonnage, des signaux de résonance magnétique au moyen d'un système d'antennes de récepteur par le biais d'une pluralité de canaux de signal, lequel système d'antennes de récepteur présente un profil de sensibilité,
    ré-échantillonner régulièrement des signaux de résonance magnétique sur une grille régulière d'échantillonnage à partir des signaux de résonance magnétique acquis sous-échantillonnés, le ré-échantillonnage impliquant une convolution des signaux de résonance magnétique acquis sous-échantillonnés avec un noyau de quadrillage dépendant du profil de sensibilité du système d'antennes de récepteur, et
    reconstruire une image de résonance magnétique à partir des signaux de résonance magnétique ré-échantillonnés, **caractérisé en ce que**
    le ré-échantillonnage est effectué pour les régions sectorielles orientées respectives dans l'espace k qui s'étendent entre des limites angulaires, entre un module minimum et maximum respectif d'un vecteur k à la périphérie de l'espace k et qui sont liées par des limites radiales qui s'étendent de façon radiale à partir de l'origine de l'espace k, et
    le noyau de quadrillage dépend également de l'orientation de la région sectorielle à l'issue.

2. Procédé d'imagerie par résonance magnétique selon la revendication 1, dans lequel les signaux de résonance magnétique sont acquis par balayage de l'espace k le long d'une trajectoire non linéaire, en particulier en spirale.

3. Procédé d'imagerie par résonance magnétique selon la revendication 1 pour former une image d'un objet dans lequel:

    - une image de résonance magnétique est dérivée de signaux de résonance magnétique sous-échantillonnés et sur la base de profils spatiaux de sensibilité d'une pluralité d'antennes réceptrices,
    - une séquence d'impulsions RF et de gradients est appliquée, laquelle séquence correspond à un ensemble de trajectoires comprenant au moins une trajectoire sensiblement non linéaire dans l'espace k dans lequel la densité d'échantillonnage dudit ensemble de trajectoires est sensiblement inférieure à la densité normale d'échantillonnage correspondant à la taille d'objet,
    - chaque signal le long dudit ensemble de trajectoires est échantillonné au moins dans deux positions différentes d'antenne de récepteur, ce qui a pour conséquence une pluralité de signaux d'antenne de récepteur,
    - l'image est reconstruite par conversion des données desdits signaux à partir dudit ensemble de trajectoires en une grille cartésienne par convolution avec un noyau de quadrillage,

et dans lequel:

- le noyau de quadrillage est une transformée de Fourier d'une configuration qui est pondérée pour chaque antenne par rapport à la grille cartésienne, et
- la configuration de noyau de quadrillage diffère entre une région et une autre dans l'espace k.

**4.** Procédé selon la revendication 1, dans lequel la configuration de pondération est obtenue en ce que

- à toute région individuelle de l'espace k, un ensemble de lignes équidistantes parallèles est assigné, lesquelles lignes s'adaptent localement audit ensemble de trajectoires,
- une configuration de points de chevauchement dans l'espace d'image est déterminée, ce qui correspond à l'ensemble de lignes équidistantes parallèles dans l'espace k,
- dans l'espace k, la configuration de pondération par antenne est calculée, laquelle configuration correspond approximativement à une configuration uniquement desdites lignes équidistantes parallèles dans la région individuelle de l'espace k.

**5.** Procédé selon la revendication 2, dans lequel au moins une partie de l'ensemble de trajectoires correspond à une spirale d'Archimède et dans lequel les régions dans l'espace k sont définies par leur angle azimutal dans l'espace k.

**6.** Procédé selon la revendication 4 ou 5, dans lequel la configuration de pondération de l'antenne est calculée selon l'inversion d'un ensemble cartésien d'équations pour les données sous-échantillonnées et les profils spatiaux de sensibilité des antennes réceptrices.

**7.** Procédé selon la revendication 6, dans lequel l'inversion dudit ensemble cartésien d'équations est formulée en tant que $A = (S^h \cdot \Psi^{-1} \cdot S + R^{-1}) \cdot S^h \cdot \Psi^{-1}$ où A est la matrice de reconstruction, S est la matrice de sensibilité d'antenne de récepteur ($s_{ij}$) où $s_{ij}$ est le profil spatial de sensibilité de l'antenne i sur le jième point de l'ensemble de chevauchement de points, $\Psi$ est la covariance de bruit entre les antennes, R est la matrice de régularisation et $S^h$ signifie le conjugué hermitien de S.

**8.** Procédé selon la revendication 7, dans lequel le noyau de quadrillage est choisi de manière à correspondre à un plus grand champ de vision qu'un champ de vision normal couvrant la taille de l'objet à étudier et dans lequel les valeurs de la matrice de régularisation R entre la marge du plus grand champ de vision et le champ de vision normale sont réglées à zéro.

**9.** Procédé selon la revendication 8, dans lequel la configuration de noyau de quadrillage pour chaque antenne qui est dérivée de la matrice de reconstruction A est multipliée par une fonction de formation commune comprenant une fonction de fenêtre conique ou la somme de carrés de sensibilités de chaque antenne.

**10.** Procédé selon l'une quelconque des revendications précédentes 5 à 9, dans lequel les fonctions de noyau de quadrillage entre les deux rayons les plus proches traversant l'ensemble en spirale de trajectoires sont interpolées.

**11.** Procédé selon la revendication 10, dans lequel les deux rayons sont quadrillés et le résultat en est interpolé.

**12.** Procédé selon l'une quelconque des revendications précédentes 1 à 11, dans lequel la région la plus centrale de l'espace k est reconstruite à la pleine densité d'échantillonnage par inversion directe et dans lequel le résultat du procédé de reconstruction de quadrillage est mélangé avec le résultat de la reconstruction à la pleine densité d'échantillonnage.

**13.** Procédé selon l'une quelconque des revendications précédentes 7 à 12, dans lequel la configuration de noyau de quadrillage pour chaque antenne qui est dérivée de la matrice de reconstruction A est divisée en un nombre défini de sous-fonctions pour lesquelles l'appui des fonctions correspondantes dans l'espace k tend à zéro afin de négliger des transitions abruptes dans la configuration de noyau de quadrillage tandis que chaque sous-fonction est quadrillée séparément.

**14.** Procédé selon la revendication 10, dans lequel les ensembles d'échantillons qui sont assignés aux rayons adjacents sont quadrillés et transformés séparément.

**15.** Utilisation de l'image qui est générée par le procédé selon l'une quelconque des revendications précédentes 1 à 14 afin d'initialiser un algorithme itératif conventionnel pour la reconstruction de l'image.

**16.** Appareil d'imagerie par résonance magnétique pour obtenir une image de résonance magnétique en provenance d'une pluralité de signaux, l'appareil d'imagerie par résonance magnétique comprenant:

- un aimant principal (51),
- une antenne d'émetteur (53, 61) pour l'excitation des rotations dans une zone prédéterminée du patient,
- une pluralité d'antennes de récepteur (53, 61) pour échantillonner des signaux dans une région restreinte d'homogénéité du champ principal d'aimant,
- une table (54) pour soutenir un patient,
- des moyens (59) pour déplacer continûment la table à travers l'alésage de l'aimant principal,
- des moyens (69 à 76) pour dériver une image de résonance magnétique à partir des signaux de résonance magnétique sous-échantillonnés et sur la base du profil spatial de sensibilité de chacune desdites positions d'antenne de récepteur,
- des moyens (69, 53, 61) pour appliquer une séquence d'impulsions RF et de gradients, laquelle séquence correspond à un ensemble de trajectoires comprenant au moins une trajectoire sensiblement non linéaire dans l'espace k dans lequel la densité dudit ensemble de trajectoires est sensiblement inférieure à la densité correspondant à la taille d'objet,
- des moyens (70, 71) pour échantillonner chaque signal le long dudit ensemble de trajectoires au moins dans deux positions différentes d'antenne de récepteur, ce qui a pour conséquence une pluralité de signaux d'antenne de récepteur,
- des moyens pour reconstruire l'image par conversion des données desdits signaux à partir dudit ensemble de trajectoires en une grille cartésienne par convolution avec un noyau de quadrillage,

**caractérisé en ce que**
lesdits moyens de reconstruction (76) sont agencés de manière à convertir les données en une grille cartésienne pour les régions sectorielles orientées respectives dans l'espace k qui s'étendent entre des limites angulaires, entre un module minimum et maximum respectif d'un vecteur k à la périphérie de l'espace k et qui sont liées par des limites radiales qui s'étendent de façon radiale à partir de l'origine de l'espace k,
le noyau de quadrillage est spécifique de chaque antenne et dépend également de l'orientation de la région sectorielle à l'issue,
la configuration de noyau de quadrillage diffère entre une région et une autre dans l'espace k, et
le noyau de quadrillage est une transformée de Fourier d'une configuration qui est pondérée pour chaque antenne par rapport à la grille cartésienne.

**17.** Appareil selon la revendication 16, comprenant encore

- des moyens (69) pour obtenir la configuration de pondération comprenant
- des moyens pour assigner, à toute région individuelle de l'espace k, un ensemble de lignes équidistantes parallèles, lesquelles lignes s'adaptent localement audit ensemble de trajectoires,
- des moyens (69) pour déterminer une configuration de points de chevauchement dans l'espace d'image, ce qui correspond à l'ensemble de lignes équidistantes parallèles dans l'espace k, et
- des moyens (69) pour calculer, dans l'espace d'image, la configuration de pondération par antenne, laquelle configuration correspond approximativement à une configuration uniquement desdites lignes équidistantes parallèles dans la région individuelle de l'espace k.

**18.** Appareil selon la revendication 17, comprenant encore des moyens (69) pour définir les régions dans l'espace k par leur angle azimutal dans l'espace k tandis qu'au moins une partie de l'ensemble de trajectoires correspond à des spirales équidistantes.

**19.** Procédé d'appareil selon la revendication 17 ou 18. comprenant encore des moyens (69, 76) pour calculer la configuration de pondération de l'antenne selon l'inversion d'un ensemble cartésien d'équations pour les données sous-échantillonnées et les profils spatiaux de sensibilité des antennes réceptrices.

**20.** Appareil selon la revendication 19, tandis que lesdits moyens (69, 76) pour calculer l'inversion dudit ensemble cartésien d'équations sont basés sur la formule $A = (S^h . \Psi^{-1} . S + R^{-1}) . S^h . \Psi^{-1}$ où A est la matrice de reconstruction, S est la matrice de sensibilité d'antenne de récepteur ($s_{ij}$) où $s_{ij}$ est le profil spatial de sensibilité de l'antenne i sur le jième point de l'ensemble de chevauchement de points, $\Psi$ est la covariance de bruit entre les antennes, R est la matrice de régularisation et S$^h$ signifie le conjugué hermitien de S.

21. Produit de programme informatique qui est stocké sur un support exploitable par ordinateur pour former une image au moyen d'un procédé de résonance magnétique comprenant des moyens de programme informatique lisibles pour effectuer que l'ordinateur commande l'exécution des étapes suivantes consistant à:

- créer un champ magnétique principal par un aimant principal,
- exciter des rotations dans une zone prédéterminée du patient par une antenne d'émetteur,
- échantillonner une pluralité de signaux dans une région restreinte d'homogénéité du champ principal d'aimant dans une pluralité de positions d'antenne de récepteur,
- déplacer continûment une table soutenant un patient à travers l'alésage de l'aimant principal,
- dériver une image de résonance magnétique à partir des signaux de résonance magnétique sous-échantillonnés et sur la base du profil spatial de sensibilité de chacune desdites positions d'antenne de récepteur,
- appliquer une séquence d'impulsions RF et de gradients, laquelle séquence correspond à un ensemble de trajectoires comprenant au moins une trajectoire sensiblement non linéaire dans l'espace k dans lequel la densité dudit ensemble de trajectoires est sensiblement inférieure à la densité correspondant à la taille d'objet,
- échantillonner chaque signal le long dudit ensemble de trajectoires au moins dans deux positions différentes d'antenne de récepteur, ce qui a pour conséquence une pluralité de signaux d'antenne de récepteur,
- reconstruire l'image par conversion des données desdits signaux à partir dudit ensemble de trajectoires en une grille cartésienne par convolution avec un noyau de quadrillage,

**caractérisé en ce que**
les données sont converties en une grille cartésienne pour les régions sectorielles orientées respectives dans l'espace k qui s'étendent entre des limites angulaires, entre un module minimum et maximum respectif d'un vecteur k à la périphérie de l'espace k et qui sont liées par des limites radiales qui s'étendent de façon radiale à partir de l'origine de l'espace k,
le noyau de quadrillage est spécifique de chaque antenne et dépend également de l'orientation de la région sectorielle à l'issue,
la configuration de noyau de quadrillage diffère entre une région et une autre dans l'espace k, et
le noyau de quadrillage est une transformée de Fourier d'une configuration qui est pondérée pour chaque antenne par rapport à la grille cartésienne.

FIG.1

FIG.2

FIG.3

FIG. 4

FIG. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2002014889 A
- WO 0173463 A

- US 20030122545 A

**Non-patent literature cited in the description**

- **M. BYDDER et al.** *Magn. Reson. Med,* 2002, vol. 10